# EUROPEAN PATENT APPLICATION

(11) **EP 4 318 567 A1**
(43) Date of publication of application: **07.02.2024**
(21) Application number: 22780197.4
(22) Date of filing: 17.03.2022
(51) Int. Cl.: H01L 23/12, H01L 23/15, H01L 23/14, H01L 21/60, H05K 1/14, H05K 3/36, H05K 3/46

(54) **MULTILAYER SUBSTRATE MANUFACTURING METHOD AND WIRING SUBSTRATE**

(30) Priority: 30.03.2021 JP 2021057939
(71) Applicant: MITSUI MINING & SMELTING CO., LTD., Tokyo 141-8584 (JP)
(72) Inventor: KITABATAKE, Yukiko, Ageo-shi, Saitama 362-0021 (JP); KOMIYA, Mikiko, Ageo-shi, Saitama 362-0021 (JP); MATSUURA, Yoshinori, Ageo-shi, Saitama 362-0021 (JP)
(74) Representative: Potter Clarkson
(86) International application number: PCT/JP2022/012390
(87) International publication number: WO 2022/209978

(57) **Abstract**

Provided is a method for manufacturing a multilayer substrate capable of suppressing short circuits between bumps and the warpage of substrates. This method includes: providing a first substrate being a rigid substrate including first bumps, and a second substrate or semiconductor device including second bumps, the first bumps and the second bumps being composed of a metal or alloy having a melting point of 600°C or more, and having a height of 0.3 µm or more; performing cleaning treatment on bonding surfaces of the first bumps and the second bumps under a pressure of 1 × 10⁻³ Pa or less, and subsequently stacking the first substrate and the second substrate or semiconductor device so that the bonding surfaces of the first bumps and the second bumps abut each other, and pressure-welding the first bumps and the second bumps at a temperature of 90°C or less to form a multilayer substrate.

## Description

### TECHNICAL FIELD

The present invention relates to methods for manufacturing a multilayer substrate and a wiring substrate.

### BACKGROUND ART

In recent years, the multilayering of printed wiring boards (wiring substrates) has been widely performed in order to increase the mounting density of the printed wiring boards for size reduction. Such multilayer printed wiring boards (multilayer substrates) are utilized in many portable electronic apparatuses for the purpose of weight reduction and size reduction. Further reduction of the thicknesses of interlayer insulating layers, and still further weight reduction as wiring substrates are required of these multilayer printed wiring boards.

As a technique for satisfying such requirements, a method for manufacturing a multilayer printed wiring board using a coreless build-up method is adopted. The coreless build-up method is a method of alternately laminating (building up) insulating layers and wiring layers for multilayering, without using a so-called core substrate. For the coreless build-up method, it is proposed to use a carrier-attached metal foil for easy release between a support and a multilayer printed wiring board. For example, Patent Literature 1 (JP2005-101 137A) discloses a method for manufacturing a package substrate for semiconductor device mounting, comprising affixing an insulating resin layer to the carrier surface of a carrier-attached copper foil to form a support, forming a first wiring conductor on the superthin copper layer side of the carrier-attached copper foil by steps such as photoresist processing, pattern electrolytic copper plating, and resist removal, then forming build-up wiring layers, releasing the carrier-attached supporting substrate, and removing the superthin copper layer.

For the fining of embedded circuits as shown in Patent Literature 1, a carrier-attached metal foil in which the thickness of a metal layer is 1 µm or less is desired. Accordingly, it is proposed to form a metal layer by a vapor phase method such as sputtering in order to achieve the reduction of the thickness of the metal layer. For example, Patent Literature 2 (WO2017/150283) discloses a carrier-attached copper foil in which a release layer, an antireflection layer, and a superthin copper layer (for example, a film thickness of 300 nm) are formed on a carrier such as a glass sheet by sputtering. Patent Literature 3 (WO2017/150284) discloses a carrier-attached copper foil in which intermediate layers (for example, an adhesion metal layer and a release-assisting layer), a release layer, and a superthin copper layer (for example, a film thickness of 300 nm) are formed on a carrier such as glass sheet by sputtering. Patent Literatures 2 and 3 also teach that intermediate layers composed of predetermined metals are interposed, and thus excellent stability of the mechanical release strength of the carrier is provided, and that the antireflection layer exhibits a desirable dark color, and thus visibility in image inspection (for example, automatic image inspection (AOI)) is improved.

Especially, with still further size reduction and power saving of electronic devices, the need for the high integration and thinning of semiconductor chips and printed wiring boards increases. As next-generation packaging techniques for satisfying such a need, the adoption of FO-WLP (Fan-Out Wafer Level Packaging) and PLP (Panel Level Packaging) has been studied in recent years. Also in FO-WLP and PLP, the adoption of the coreless build-up method is studied. One such method is a method referred to as an RDL-First (Redistribution Layer-First) method in which a wiring layer, and build-up wiring layers as needed, are formed on a coreless support surface, then chips are mounted and sealed, and subsequently the support is released. For example, Patent Literature 4 (JP2015-35551A) discloses a method for manufacturing a semiconductor apparatus, comprising the formation of a metal release layer on a major surface of a support composed of glass or a silicon wafer, the formation of an insulating resin layer on the metal release layer, the formation of a Redistribution Layer comprising build-up layers on the insulating resin layer, the mounting and sealing of semiconductor integrated circuits on the Redistribution Layer, the exposure of the release layer by the removal of the support, the exposure of secondary mounting pads by the removal of the release layer, and the formation of solder bumps on the surfaces of the secondary mounting pads, and secondary mounting.

Meanwhile, as a method for mounting a semiconductor chip or the like on a wiring substrate, a flip chip technique is widely used. In the flip chip technique, chip mounting is performed, for example, by connecting mounting pads (bumps) on the semiconductor chip side, and electrodes (bumps) having a protrusion shape formed on the redistribution layer or the like of a wiring substrate. At this time, for electrical connection between the bumps, generally, solder (for example, SnAg solder) is previously adhered to the bumps on the wiring substrate side, and then the semiconductor chip is mounted. In such a method, by heating the wiring substrate after semiconductor chip lamination, the solder melts, and the bumps are bonded.

However, when the spacing between adjacent bumps narrows (for example, a wire-to-wire distance of 10 µm) with an increase in the number of terminals due to the fining of wiring, there is a high possibility of the occurrence of short circuits when connection between bumps is performed by the above method. In other words, when bumps are bonded by solder melted by heating a wiring substrate, solder projecting from bumps may reach adjacent bumps during the melting to cause short circuits.

Therefore, methods for performing the chip mounting of a wiring substrate without solder are proposed. For example, Patent Literature 5 (JP5159273B) discloses that regarding a method for manufacturing an electronic apparatus, by sandwiching and pressing a wiring body and two laminates composed of a first semiconductor chip and a second semiconductor chip by a press heater at a predetermined temperature, the wiring body and the laminates are fixed. Patent Literature 6 (JP5699891B) discloses a method for manufacturing an electronic apparatus, comprising the step of thermocompression-bonding first electrodes provided on the major surface of a first electronic component, and second electrodes provided on the major surface of a second electronic component.

### CITATION LIST

### PATENT LITERATURE

Patent Literature 1: JP2005-101137A
Patent Literature 2: WO2017/150283
Patent Literature 3: WO2017/150284
Patent Literature 4: JP2015-35551A
Patent Literature 5: JP5159273B
Patent Literature 6: JP5699891B

### SUMMARY OF INVENTION

However, in the chip mounting methods as disclosed in Patent Literatures 5 and 6, warpage may occur in the wiring substrate due to heat treatment. In other words, when thermocompression bonding is performed at a temperature at which a metal constituting bumps diffuses sufficiently, warpage, deformation, and the like may occur in the substrate due to the shrinkage of the wiring and the resin between the wires. In this manner, it is difficult to suppress short circuits between bumps in the surface direction and the warpage of a substrate while bonding upper and lower bumps.

The present inventors have now found that in the bonding of a rigid substrate and another substrate or a semiconductor device, by performing the cleaning treatment of the bonding surfaces of predetermined bumps provided in these substrates, and then pressure-welding the bumps to each other at a predetermined temperature or less, it is possible to manufacture a multilayer substrate in which short circuits between bumps and the warpage of substrates are suppressed.

Therefore, an object of the present invention is to provide a method for manufacturing a multilayer substrate in which short circuits between bumps and the warpage of substrates can be suppressed.

According to an aspect of the present invention, there is provided a method for manufacturing a multilayer substrate, comprising the steps of:
providing a first substrate being a rigid substrate comprising a plurality of first bumps on a surface in a predetermined arrangement, and a second substrate or semiconductor device comprising a plurality of second bumps on a surface in an arrangement corresponding to the predetermined arrangement, each of the first bumps and the second bumps being composed of a metal or alloy having a melting point of 600°C or more, and having a height of 0.3 µm or more;
performing cleaning treatment on bonding surfaces of the first bumps and bonding surfaces of the second bumps in an atmosphere at a pressure of 1 × 10⁻³ Pa or less; and
subsequently stacking the first substrate and the second substrate or semiconductor device in an atmosphere at a pressure of 1 × 10⁻³ Pa or less so that the bonding surfaces of the first bumps and the bonding surfaces of the second bumps abut each other, and pressure-welding the first bumps and the second bumps at a temperature of 90°C or less to form a multilayer substrate.

According to another aspect of the present invention, there is provided a wiring substrate comprising:
a first substrate being a rigid substrate;
a second substrate; and
a plurality of bumps interposed between the first substrate and the second substrate and bonding the first substrate and the second substrate,
wherein the bumps are composed of a metal or alloy having a melting point of 600°C or more and have a height of 0.6 µm or more.

### BRIEF DESCRIPTION OF DRAWINGS

Figure 1A is a process flow chart showing in a schematic cross-sectional view of one example of a method for manufacturing a multilayer substrate according to the present invention and is a view showing the initial steps (steps (i) and (ii)).
Figure 1B is a process flow chart showing in a schematic cross-sectional view of the one example of the method for manufacturing a multilayer substrate according to the present invention and is a view showing the steps (steps (iii) and (iv)) following Figure 1A.
Figure 1C is a process flow chart showing in a schematic cross-sectional view of the one example of the method for manufacturing a multilayer substrate according to the present invention and is a view showing the steps (steps (v) and (vi)) following Figure 1B.
Figure 2 is a schematic view showing the height H, diameter D, and pitch P (center-to-center distance) of bumps.
Figure 3 is a schematic cross-sectional view showing one aspect of a wiring substrate according to the present invention.
Figure 4 is an optical microscope observation image (magnification: 100x) of the first bumps provided on the first substrate in Example A1.
Figure 5 is a scanning electron microscope (SEM) observation image (magnification: 2000x) of the first bumps provided on the first substrate in Example A1.
Figure 6A is a schematic cross-sectional view of the first substrate comprising the pillars fabricated in Example A2.
Figure 6B is a schematic top view in which the first substrate shown in Figure 6A is seen from the redistribution layer side.
Figure 7 is a schematic cross-sectional view of the multilayer substrate comprising the pillars fabricated in Example A2.
Figure 8 is an SEM observation image (magnification: 10000x) of a bump after etching treatment in Example B1, B3, or B5 to B8.
Figure 9 is an SEM observation image (magnification: 10000x) of a bump after etching treatment in Example B2.

### DESCRIPTION OF EMBODIMENTS

### Method for Manufacturing Multilayer Substrate

The present invention relates to a method for manufacturing a multilayer substrate. The method of the present invention comprises the steps of (1) the provision of a first substrate and second substrates or semiconductor devices, (2) the cleaning treatment of bump bonding surfaces, (3) pressure welding treatment, (4) underfill filling optionally performed, (5) resin sealing optionally performed, and (6) the release and removal of the carrier optionally performed.

Each of the steps (1) to (6) will be described below with reference to the drawings.

### (1) Provision of First Substrate and Second Substrates or Semiconductor Devices

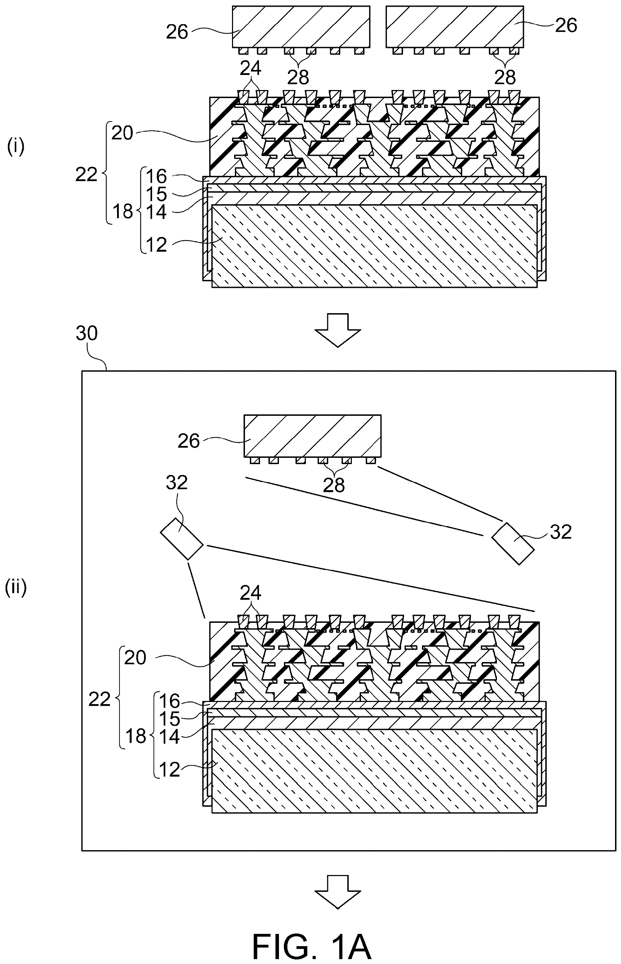

One example of the method for manufacturing a multilayer substrate according to the present invention is shown in Figures 1A to 1C. First, as shown in Figure 1A(i), a first substrate 22 comprising a plurality of first bumps 24 on a surface in a predetermined arrangement is provided. In addition, second substrates or semiconductor devices 26 comprising a plurality of second bumps 28 on surfaces are provided. The second bumps 28 are provided on the second substrate or semiconductor device 26 surfaces in an arrangement corresponding to the first bumps 24 provided on the first substrate 22 surface.

The first substrate 22 is a rigid substrate and preferably has an elastic modulus of 30 GPa or more and 600 GPa or less, more preferably 40 GPa or more and 400 GPa or less, further preferably 50 GPa or more and 250 GPa or less, and particularly preferably 60 GPa or more and 150 GPa or less. The first substrate 22 has rigidity, and thus the pressure welding of the bumps described later can be preferably performed.

The first substrate 22 is preferably a rigid substrate comprising a rigid carrier 12, a redistribution layer 20 on the rigid carrier 12, and the plurality of first bumps 24 on the redistribution layer 20. In this case, the rigid carrier 12 preferably has the above-described elastic modulus. The redistribution layer 20 may be formed on a carrier-attached metal foil 18. The formation of the redistribution layer 20 should be performed by a known method and is not particularly limited. For example, the redistribution layer 20 can be preferably formed by alternately laminating insulating layers and wiring layers for multilayering by the above-described coreless build-up method. The rigid carrier 12, an intermediate layer 14 (when present), a release layer 15, and a metal layer 16 may be herein collectively referred to as "the carrier-attached metal foil 18". A preferred aspect of the carrier-attached metal foil 18 will be described later.

The material of the rigid carrier 12 optionally constituting the first substrate 22 is not particularly limited as long as it has the desired rigidity. The rigid carrier 12 may be composed of any of glass, ceramic, a substrate comprising silicon, a resin, and a metal but is preferably a substrate comprising silicon or a glass substrate. Of these, the substrate comprising silicon may be any substrate as long as it comprises Si as an element. A SiO₂ substrate, a SiN substrate, a Si single crystal substrate, a Si polycrystalline substrate, and the like can be applied. More preferably, the rigid carrier 12 is a glass carrier, a single crystal silicon substrate, or a polycrystalline silicon substrate. According to a preferred aspect of the present invention, the rigid carrier 12 has a rectangular shape having a short side of 100 mm or more, more preferably a rectangular shape having a short side of 150 mm or more and 600 mm or less and a long side of 200 mm or more and 650 mm or less. According to another preferred aspect of the present invention, the rigid carrier 12 has a disk shape having a diameter of 100 mm or more, more preferably a disk shape having a diameter of 200 mm or more and 450 mm or less.

The configuration of the second substrate should follow the first substrate 22 except that the second substrate need not necessarily be a rigid substrate. Therefore, the preferred aspects concerning the first substrate 22 also apply to the second substrate as they are. However, the second substrate may be a rigid substrate. In this case, at least one of the first substrate 22 and the second substrate preferably has the above-described elastic modulus. The second substrate can be a rigid substrate comprising a rigid carrier, a redistribution layer on the rigid carrier, and the plurality of second bumps 28 on the redistribution layer. Therefore, at least one of the first substrate 22 and the second substrate preferably comprises glass, silicon, or alumina, more preferably glass.

The semiconductor device 26 should have the desired device function, and its type is not particularly limited. Preferred examples of the semiconductor device 26 include GaN, SiC, Si, an alumina substrate, a zirconia substrate, and a ceramic substrate. Two or more semiconductor devices 26 may be provided for one first substrate 22, and the number of the semiconductor devices 26 is not particularly limited.

Each of the first bumps 24 provided on the first substrate 22 surface and the second bumps 28 provided on the second substrate or semiconductor device 26 surfaces are composed of a metal or alloy having a melting point of 600°C or more so that short circuits between the bumps can be effectively suppressed. The first bumps 24 and the second bumps 28 each preferably consist of the metal or alloy but may comprise unavoidable impurities. The first bumps 24 and the second bumps 28 are each preferably composed of a transition metal, more preferably at least one selected from the group consisting of Au, Ag, and Cu, and further preferably Cu. Especially, the first bumps 24 and the second bumps 28 are both preferably composed of Cu metal. The bumps in the present invention are bonding members for mounting, on a substrate, semiconductor devices or other substrates and include objects generally referred to as pads, pillars, or posts.

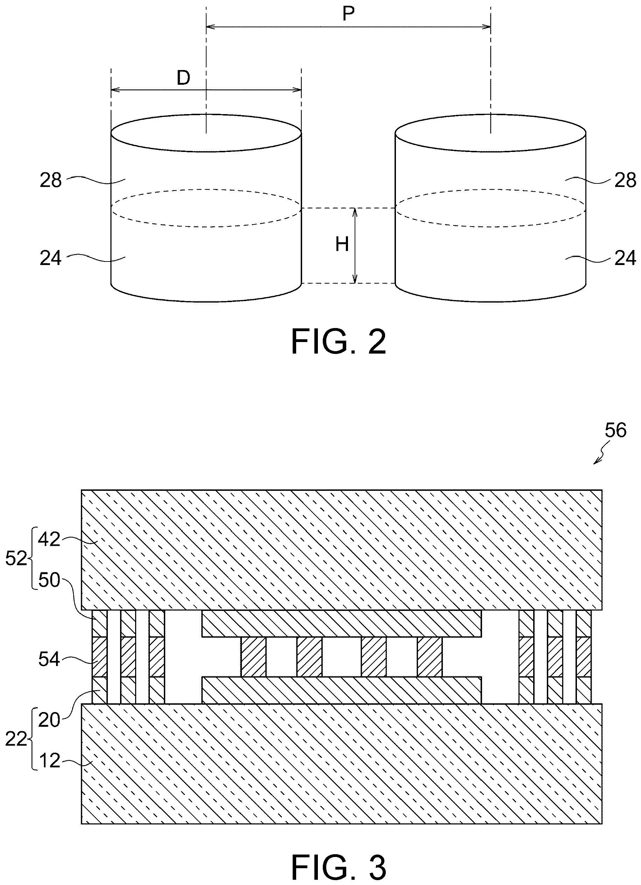

One aspect of the first bumps 24 and the second bumps 28 is shown in Figure 2. As shown in Figure 2, the first bumps 24 and the second bumps 28 each have a height H of 0.3 µm or more, preferably 0.5 µm or more and 200 µm or less, further preferably 0.7 µm or more and 150 µm or less, particularly preferably 0.9 µm or more and 100 µm or less, and most preferably 1 µm or more and 50 µm or less. Thus, in the pressure welding of the first bumps 24 and the second bumps 28 described later, diffusion bonding between the bumps is preferably performed, and the first substrate 22 and the second substrates or semiconductor devices 26 can be strongly bonded. By performing resin sealing and the like described later, as needed, the rigidity of an entire multilayer substrate 34 can be further improved.

As shown in Figure 2, the first bumps 24 and the second bumps 28 each preferably have a circular shape or a cylindrical shape. In such a case, the first bumps 24 and the second bumps 28 each preferably have a diameter D of 1 µm or more and 50 µm or less, more preferably 2 µm or more and 35 µm or less, further preferably 3 µm or more and 30 µm or less, particularly preferably 4 µm or more and 25 µm or less, and most preferably 5 µm or more and 20 µm or less. Further, the first bumps 24 and the second bumps 28 are preferably regularly arranged at a pitch P (center-to-center distance) of 1 µm or more and 40 µm or less, more preferably 2 µm or more and 35 µm or less, further preferably 5 µm or more and 30 µm or less, particularly preferably 7 µm or more and 25 µm or less, and most preferably 8 µm or more and 20 µm or less in a range in which the bumps are not in contact with each other in the substrate surfaces. Thus, the diffusion bonding between the bumps can be more preferably performed.

The bonding surfaces (that is, the surfaces that abut the second bumps 28 during pressure welding treatment described later) of the first bumps 24 and the bonding surfaces (that is, the surfaces that abut the first bumps 24 during pressure welding treatment described later) of the second bumps 28 each preferably have an arithmetic mean height Sa of 0.1 nm or more and 70 nm or less, more preferably 0.2 nm or more and 60 nm or less, further preferably 0.3 nm or more and 50 nm or less, and particularly preferably 0.5 nm or more and 40 nm or less. Thus, the diffusion bonding between the bumps can be more preferably performed. The measurement of the arithmetic mean height Sa can be performed in accordance with a standard such as ISO 25178 according to the various conditions described in Examples herein, using a commercially available 3D surface roughness shape measuring machine.

### (2) Cleaning Treatment of Bump Bonding Surfaces

As shown in Figure 1A(ii), cleaning treatment is performed on the bonding surfaces of the first bumps 24 and the bonding surfaces of the second bumps 28 in an atmosphere at a pressure of 1 × 10⁻³ Pa or less. Thus, the bonding surfaces of the first bumps 24 and the bonding surfaces of the second bumps 28 are activated. In other words, usually, oxide layers and adsorption layers (impurity layers) are present on bump surfaces composed of a metal or an alloy. In this respect, by performing cleaning treatment in the above atmosphere, the oxide layers or the adsorption layers on the bump surfaces are removed, and the bonds of the metal atoms constituting the bonding surfaces of the bumps appear (that is, the surfaces are activated). Then, by bringing the bonding surfaces of the bumps activated into contact with each other, bonding force acts, and the bumps are strongly bonded. In this manner, according to the present invention, the first bumps 24 and the second bumps 28 can be bonded at a temperature of 90°C or less as described later though bumps having a high melting point of 600°C or more are used. As a result, the warpage of the substrates, and the like accompanying heat treatment can be preferably suppressed.

The cleaning treatment (and the pressure welding treatment described later) is performed in an atmosphere at a pressure of 1 × 10⁻³ Pa or less, preferably 1 × 10⁻⁴ Pa or less, and more preferably 1 × 10⁻⁵ Pa or less. The lower limit value of the pressure is not particularly limited and may be 0 Pa but is practically 1 × 10⁻⁸ Pa or more. The above atmosphere may be either of a vacuum atmosphere and an inert gas (for example, nitrogen gas) atmosphere but is preferably a vacuum atmosphere. For example, by conveying the first substrate 22 and the second substrate or semiconductor device 26 into a vacuum chamber 30, as shown in Figure 1A(ii), and then discharging gas from inside the vacuum chamber 30 using an evacuation apparatus (for example, a vacuum pump), a vacuum atmosphere can be provided inside the vacuum chamber 30.

The cleaning treatment is preferably at least one selected from the group consisting of ion beam irradiation, neutral atom beam irradiation, and inert gas plasma treatment, more preferably neutral atom beam irradiation. For example, by radiating ion beams (for example, argon ion beams) or neutral atom beams (for example, argon atom beams) from beam sources 32 toward the surface of the first substrate 22 on the first bump 24 side and the surface of the second substrate or semiconductor device 26 on the second bump 28 side, as shown in Figure 1A(ii), the bonding surfaces of the first bumps 24 and the bonding surfaces of the second bumps 28 can be preferably activated. This cleaning treatment can be preferably performed using a commercially available room temperature wafer bonding apparatus (for example, "BOND MEISTER" manufactured by Mitsubishi Heavy Industries Machine Tool Co., Ltd.).

### (3) Pressure Welding Treatment

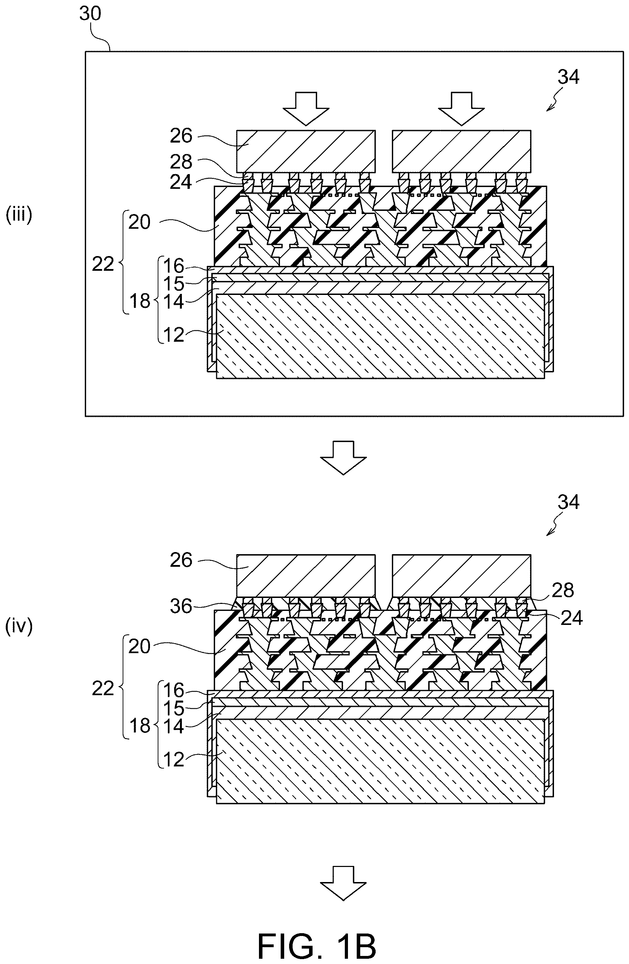

As shown in Figure 1B(iii), subsequently in an atmosphere at a pressure of 1 × 10⁻³ Pa or less, the first substrate 22 and the second substrates or semiconductor devices 26 are stacked so that the bonding surfaces of the first bumps 24 (activated) and the bonding surfaces of the second bumps 28 (activated) abut each other, and the first bumps 24 and the second bumps 28 are pressure-welded at a temperature of 90°C or less. Thus, a multilayer substrate 34 in which the first substrate 22 and the second substrates or semiconductor devices 26 are bonded are formed. Thus, the multilayer substrate 34 in which short circuits between bumps adjacent in the surface directions of substrates and the warpage of the substrates are suppressed can be manufactured.

As described above, it is generally difficult to also suppress the warpage of a substrate while suppressing short circuits between bumps. In other words, in the conventional methods as disclosed in Patent Literatures 5 and 6, chip mounting and the like are performed by thermocompression bonding at a temperature at which a metal or alloy constituting bumps diffuses sufficiently (for example, 260°C or more). In such a case, short circuits between the wires or between the bumps can be prevented, but the wiring and the resin (for example, a photosensitive polyimide) between the wires shrink due to the heat treatment, and the deformation of the substrate may occur. In other words, due to the difference between the coefficients of thermal expansion of the materials constituting the substrate, a difference in shrinkage ratio during cooling occurs, and as a result, trouble such as the warpage of a molded article, and the displacement of the positions of the chips from the design can occur. Particularly, substrates applied to FO-WLP and PLP, next-generation packaging techniques, described above are susceptible to warpage during redistribution layer formation because the height of packages is reduced compared with conventional ones, and the trouble is significant.

In contrast to this, according to the present invention, the pressure welding of the bonding surfaces of the bumps activated, to each other can be performed in an environment without intentional heating and/or cooling. In other words, direct bonding can be performed at a low temperature of 90°C or less, and therefore the warpage of the substrates can be effectively suppressed. Moreover, according to the present invention, no solder is interposed between the bumps, and therefore there is no possibility that solder spreads, and even when the first substrate 22 or the second substrates have fine pitch (for example, on the order of several µm) wiring, short circuits between the wires or between the bumps can be effectively suppressed by arranging the bumps on the first substrate 22 and the second substrates (or the semiconductor devices 26) at facing positions.

The pressure welding of the first bumps 24 and the second bumps 28 is preferably performed so as to apply a surface pressure of 10 MPa or more and 350 MPa or less, more preferably 30 MPa or more and 300 MPa or less, and further preferably 50 MPa or more and 200 MPa or less to the bonding surfaces of the first bumps 24 and the bonding surfaces of the second bumps 28. The pressure welding of the first bumps 24 and the second bumps 28 is preferably continuously performed in the vacuum chamber 30 in which the cleaning treatment is performed. Such continuous treatment can be preferably performed using a commercially available room temperature wafer bonding apparatus (for example, "BOND MEISTER" manufactured by Mitsubishi Heavy Industries Machine Tool Co., Ltd.).

From the viewpoint of more effectively suppressing the warpage of the multilayer substrate 34, the pressure welding of the first bumps 24 and the second bumps 28 is preferably performed in an environment without intentional heating and/or cooling. However, from the viewpoint of making the bonding of the first bumps 24 and the second bumps 28 stronger, pressure welding involving heating at a predetermined temperature or less is allowed. In this case, the temperature during the pressure welding is preferably 90°C or less, more preferably -30°C or more and 80°C or less, and further preferably - 20°C or more and 45°C or less.

### (4) Underfill Filling (Optional Step)

As shown in Figure 1B(iv), after the pressure welding of the first bumps 24 and the second bumps 28, the gaps between the first substrate 22 and the second substrates or semiconductor devices 26 may be filled with a resin (for example, a liquid curable resin) to form resin layers 36 covering the first bumps 24 and the second bumps 28. Thus, the first substrate 22 and the second substrates or semiconductor devices 26 can be more strongly bonded to improve the vibration resistance and heat resistance of the multilayer substrate 34.

Preferred examples of the filling resin include epoxy resins, phenolic resins, and combinations thereof, more preferably epoxy resins.

### (5) Resin Sealing (Optional Step)

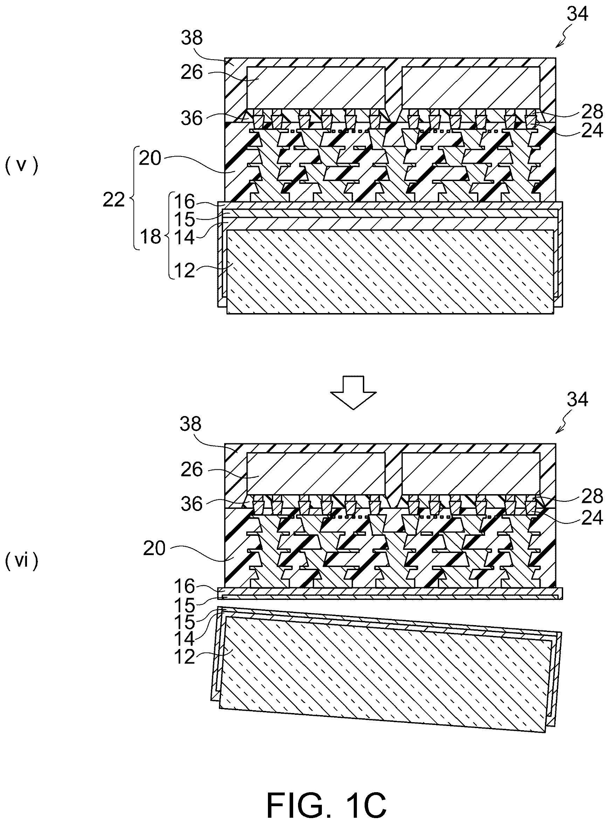

When the semiconductor devices 26 are bonded to the first substrate 22, the semiconductor devices 26 are preferably resin-sealed with a sealing material 38, as shown in Figure 1C(v). Thus, the rigidity of the entire multilayer substrate 34 can be further improved. The sealing material 38 should be composed of a known material (for example, an epoxy resin) used for the resin sealing of semiconductor devices (for example, Si chips) and is not particularly limited.

### (6) Release and Removal of Carrier (Optional Step)

When the first substrate 22 comprises the carrier-attached metal foil 18, the rigid carrier 12 and the intermediate layer 14 (when present) may be optionally released and removed from the multilayer substrate 34 at the position of the release layer 15, as shown in Figure 1C(vi). This release and removal is preferably performed by physical release. The physical release method is a method in which separation is performed by releasing the rigid carrier 12 from the multilayer substrate 34 by hand, a tool, a machine, or the like. The metal layer 16 exposed after the release of the rigid carrier 12 may be optionally removed by etching or chemical mechanical polishing (CMP) treatment.

When the rigid carrier 12 is a single crystal silicon carrier, the direction of the progress of the release is preferably noted. A single crystal silicon carrier typically has a notch or an orientation flat in the outer peripheral portion in order to show the reference point of the crystal orientation. Generally, when the diameter of single crystal silicon is 200 mm or less, an orientation flat is formed, and when the diameter of single crystal silicon is 200 mm or more, a notch is formed. The notch and orientation flat may be hereinafter collectively referred to as a "notch or the like".

When release is performed in directions in which a direction in which external stress progresses matches cleavage orientation, there is a possibility of the breakage of a silicon carrier, such as the occurrence of a crack along the cleavage orientation starting from the point to which the external stress due to the first release is applied. In order to suppress such breakage of a silicon carrier due to cleavage, when the rigid carrier 12 is a single crystal silicon carrier, external stress is preferably applied so as to mismatch all directions of the cleavage orientation in the silicon carrier, to perform the release of the carrier 12.

Therefore, according to a preferred aspect of the present invention, the rigid carrier 12 is a single crystal silicon carrier having a notch or the like in the outer peripheral portion, and in the step of releasing the carrier, release is performed so that when an angle θ is defined right-handed (clockwise) starting from the half line from the center of the single crystal silicon carrier to the notch or the like, the direction of the progress of external stress is within the range of 1° < θ < 89°

### Wiring Substrate

According to a preferred aspect of the present invention, a wiring substrate is provided. A wiring substrate according to the present invention is conceptually shown in Figure 3. As shown in Figure 3, the wiring substrate 56 of the present invention comprises a first substrate 22, a second substrate 52, and a plurality of bumps 54. The first substrate 22 is a rigid substrate. The plurality of bumps 54 are interposed between the first substrate 22 and the second substrate 52 and bond the first substrate 22 and the second substrate 52. The bumps 54 are composed of a metal or alloy having a melting point of 600°C or more and have a height of 0.6 µm or more.

The wiring substrate 56 may be manufactured by any method. Typically, the wiring substrate 56 corresponds to the multilayer substrate 34 after the first substrate 22 comprising the first bumps 24 and the second substrate comprising the second bumps 28 are bonded in the method for manufacturing a multilayer substrate described above. Therefore, the first substrate 22, the second substrate 52, and the bumps 54 included in the wiring substrate 56 are as described above regarding the first substrate 22 comprising the first bumps 24 and the second substrate comprising the second bumps 28 included in the multilayer substrate 34. Therefore, the bumps 54 comprise no bonding material such as solder in their intermediate portions. Because of ease of manufacture, the bumps 54 preferably have a single composition.

For example, it is preferred that as shown in Figure 3, the first substrate 22 is a rigid substrate comprising a rigid carrier 12 and a redistribution layer 20 on the rigid carrier 12, and the redistribution layer 20 and the second substrate 52 are bonded by the plurality of bumps 54. The second substrate 42 may be a rigid substrate comprising a rigid carrier 42 and a redistribution layer 50 on the rigid carrier 42. The rigid carriers 12 and 42 are preferably composed of glass, silicon, or alumina.

The bumps 54 have a height of 0.6 µm or more, preferably 1.0 µm or more and 400 µm or less, more preferably 1.4 µm or more and 300 µm or less, further preferably 1.8 µm or more and 200 µm or less, and most preferably 2 µm or more and 100 µm or less. The bumps 54 are preferably regularly arranged at a pitch (center-to-center distance) of 1 µm or more and 40 µm or less, more preferably 2 µm or more and 35 µm or less, further preferably 5 µm or more and 30 µm or less, particularly preferably 7 µm or more and 25 µm or less, and most preferably 8 µm or more and 20 µm or less, like the first bumps 24 and the second bumps 28.

### Carrier-Attached Metal Foil

As described above with reference to Figure 1A, the carrier-attached metal foil 18 optionally used in the method of the present invention comprises the rigid carrier 12, optionally the intermediate layer 14, the release layer 15, and the metal layer 16 in order.

As described above, the material of the rigid carrier 12 may be any of glass, ceramic, a substrate comprising silicon, a resin, and a metal. In other words, the rigid carrier 12 is preferably one that can function as a support having rigidity, such as a glass plate, a ceramic plate, a silicon wafer, or a metal plate. Preferably, the rigid carrier 12 is composed of glass, a substrate comprising silicon, or alumina. More preferably, the rigid carrier 12 is a glass carrier, a single crystal silicon substrate, or a polycrystalline silicon substrate. Preferred examples of the metal constituting the rigid carrier 12 include copper, titanium, nickel, stainless steel, and aluminum. Preferred examples of the ceramic include alumina, zirconia, silicon nitride, aluminum nitride, and various other fine ceramics. Preferred examples of the resin include polyethylene terephthalate (PET), polyethylene naphthalate (PEN), polyamides, polyimides, nylons, liquid crystal polymers, polyetheretherketone (PEEK (^{®})), polyamide-imides, polyethersulfone, polyphenylene sulfide, polytetrafluoroethylene (PTFE), and ethylene tetrafluoroethylene (ETFE). More preferably, from the viewpoint of preventing the warpage of a coreless support accompanying heating, the rigid carrier 12 is a material having a coefficient of thermal expansion (CTE) of less than 25 ppm/K (typically 1.0 ppm/K or more and 23 ppm/K or less). Examples of such a material include various resins (particularly low thermal expansion resins such as polyimides and liquid crystal polymers), glass, substrates comprising silicon, and ceramics as described above. From the viewpoint of handleabililty and ensuring flatness during chip mounting, the rigid carrier 12 preferably has an elastic modulus of 30 GPa or more and 600 GPa or less, more preferably 40 GPa or more and 400 GPa or less, further preferably 50 GPa or more and 250 GPa or less, and particularly preferably 60 GPa or more and 150 GPa or less. As a material satisfying these characteristics, the rigid carrier 12 is preferably composed of glass, a substrate comprising silicon, or ceramic (for example, alumina), more preferably glass, a substrate comprising silicon, or ceramic, and particularly preferably glass or a substrate comprising silicon. Examples of the rigid carrier 12 composed of glass include a glass plate. When glass is used as the rigid carrier 12, advantages are that it is lightweight, has a low coefficient of thermal expansion, has high insulating properties, and is rigid and has a flat surface and therefore the surface of the metal layer 16 can be extremely smoothed. In addition, when the rigid carrier 12 is glass, advantages are that it has surface flatness (coplanarity) advantageous for fine circuit formation, that it has chemical resistance in desmear and various plating steps in a wiring manufacturing process, and that a chemical separation method can be adopted when the rigid carrier 12 is released from the carrier-attached metal foil 18. Preferred examples of the glass constituting the rigid carrier 12 include quartz glass, borosilicate glass, alkali-free glass, soda lime glass, aluminosilicate glass, and combinations thereof, more preferably alkali-free glass, soda lime glass, and combinations thereof, and particularly preferably alkali-free glass. The alkali-free glass is glass containing substantially no alkali metals that comprises silicon dioxide, aluminum oxide, boron oxide, and alkaline earth metal oxides such as calcium oxide and barium oxide as main components and further contains boric acid. An advantage of this alkali-free glass is that it has a low coefficient of thermal expansion in the range of 3 ppm/K or more and 5 ppm/K or less and is stable in a wide temperature zone of 0°C to 350°C, and therefore the warpage of the glass in a process involving heating can be minimized. When a substrate comprising silicon is used as the rigid carrier 12, advantages are that, like glass, it is lightweight, has a low coefficient of thermal expansion, has high insulating properties, and is rigid and has a flat surface and therefore the surface of the metal layer 16 can be extremely smoothed. In addition, when the rigid carrier 12 is a substrate comprising silicon, advantages are that it has surface flatness (coplanarity) advantageous for fine circuit formation, that it has chemical resistance in desmear and various plating steps in a wiring manufacturing process, and that a chemical separation method can be adopted when the rigid carrier 12 is released from the carrier-attached metal foil 18. The substrate comprising silicon constituting the rigid carrier 12 may be any substrate as long as it comprises Si as an element. A SiO₂ substrate, a SiN substrate, a Si single crystal substrate, a Si polycrystalline substrate, and the like can be applied. The thickness of the rigid carrier 12 is preferably 100 µm or more and 2000 µm or less, more preferably 300 µm or more and 1800 µm or less, and further preferably 400 µm or more and 1100 µm or less. When the rigid carrier 12 has a thickness within such a range, the thinning of wiring, and the reduction of warpage that occurs during electronic component mounting can be achieved while suitable strength that does not hinder handling is ensured.

The intermediate layer 14 provided as desired may have a one-layer configuration or a configuration of two or more layers. When the intermediate layer 14 is composed of two or more layers, the intermediate layer 14 comprises a first intermediate layer provided directly on the rigid carrier 12, and a second intermediate layer provided adjacent to the release layer 15. The first intermediate layer is preferably a layer composed of at least one metal selected from the group consisting of Ti, Cr, Al, and Ni, in terms of ensuring adhesion to the rigid carrier 12. The first intermediate layer may be a pure metal or an alloy. The thickness of the first intermediate layer is preferably 5 nm or more and 500 nm or less, more preferably 10 nm or more and 300 nm or less, further preferably 18 nm or more and 200 nm or less, and particularly preferably 20 nm or more and 100 nm or less. The second intermediate layer is preferably a layer composed of Cu, in terms of controlling the release strength between the second intermediate layer and the release layer 15 at the desired value. The thickness of the second intermediate layer is preferably 5 nm or more and 500 nm or less, more preferably 10 nm or more and 400 nm or less, further preferably 15 nm or more and 300 nm or less, and particularly preferably 20 nm or more and 200 nm or less. Another interposed layer may be present between the first intermediate layer and the second intermediate layer, and examples of the constituent material of the interposed layer include alloys of at least one metal selected from the group consisting of Ti, Cr, Mo, Mn, W, and Ni, and Cu. On the other hand, when the intermediate layer 14 has a one-layer configuration, the first intermediate layer may be adopted as the intermediate layer as it is, or the first intermediate layer and the second intermediate layer may be replaced by one intermediate alloy layer. This intermediate alloy layer is preferably composed of a copper alloy in which the content of at least one metal selected from the group consisting of Ti, Cr, Mo, Mn, W, Al, and Ni is 1.0 at % or more, and the Cu content is 30 at % or more. The thickness of the intermediate alloy layer is preferably 5 nm or more and 500 nm or less, more preferably 10 nm or more and 400 nm or less, further preferably 15 nm or more and 300 nm or less, and particularly preferably 20 nm or more and 200 nm or less. The thicknesses of layers described above are values measured by analyzing a layer cross section by a transmission electron microscope-energy dispersive X-ray spectrometer (TEM-EDX). The metal constituting the intermediate layer 14 may comprise unavoidable impurities due to the raw material component, the film formation step, and the like. In the case of exposure to the air after the film formation of the intermediate layer 14, the presence of oxygen mixed due to the exposure is allowed, which is not particularly limited. The intermediate layer 14 may be manufactured by any method but is particularly preferably a layer formed by a magnetron sputtering method using a metal target, in terms of being able to have the uniformity of film thickness distribution.

The release layer 15 is a layer that allows or facilitates the release of the rigid carrier 12, and the intermediate layer 14 when it is present. The release layer 15 may be one that can be released by a method of release with a laser beam (laser lift-off, LLO), in addition to one that can be released by a method of physically applying force. When the release layer 15 is composed of a material that can be released by laser lift-off, the release layer 15 may be composed of a resin with which the adhesion strength of the interface decreases by laser beam irradiation after curing, or may be a layer of silicon, silicon carbide, or the like that is modified by laser beam irradiation. In addition, the release layer 15 may be either of an organic release layer and an inorganic release layer. Examples of the organic component used for the organic release layer include nitrogen-containing organic compounds, sulfur-containing organic compounds, and carboxylic acids. Examples of the nitrogen-containing organic compounds include triazole compounds and imidazole compounds. On the other hand, examples of the inorganic component used for the inorganic release layer include metal oxides or metal oxynitrides comprising at least one or more of Cu, Ti, Al, Nb, Zr, Cr, W, Ta, Co, Ag, Ni, In, Sn, Zn, Ga, and Mo, or carbon. Among these, the release layer 15 is preferably a layer mainly comprising carbon, in terms of ease of release, layer-forming properties, and the like, more preferably a layer mainly composed of carbon or a hydrocarbon, and further preferably a layer composed of amorphous carbon, a hard carbon film. In this case, the release layer 15 (that is, a carbon-containing layer) preferably has a carbon concentration of 60 atomic % or more, more preferably 70 atomic % or more, further preferably 80 atomic % or more, and particularly preferably 85 atomic % or more as measured by XPS. The upper limit value of the carbon concentration is not particularly limited and may be 100 atomic % but is practically 98 atomic % or less. The release layer 15 can comprise unavoidable impurities (for example, oxygen, carbon, and hydrogen derived from the surrounding environment such as an atmosphere). In the release layer 15, atoms of metals of types other than the metal contained as the release layer 15 can be mixed due to the film formation method of the metal layer 16 or the like laminated later. When a carbon-containing layer is used as the release layer 15, the interdiffusivity and reactivity with the rigid carrier are low, and even if the carrier-attached metal foil 18 is subjected to pressing at a temperature of more than 300°C, the formation of metallic bonds between the metal layer and the bonding interface due to high temperature heating can be prevented to maintain a state in which the release and removal of the rigid carrier is easy. The release layer 15 is preferably a layer formed by a vapor phase method such as sputtering, in terms of suppressing excessive impurities in the release layer 15, and in terms of the continuous productivity of other layers, and the like. The thickness when a carbon-containing layer is used as the release layer 15 is preferably 1 nm or more and 20 nm or less, more preferably 1 nm or more and 10 nm or less. This thickness is a value measured by analyzing a layer cross section by a transmission electron microscope-energy dispersive X-ray spectrometer (TEM-EDX).

The release layer 15 may comprise each layer of a metal oxide layer and a carbon-containing layer or be a layer comprising both a metal oxide and carbon. Particularly, when the carrier-attached metal foil 18 comprises the intermediate layer 14, the carbon-containing layer can contribute to the stable release of the rigid carrier 12, and the metal oxide layer can suppress the diffusion of the metal elements derived from the intermediate layer 14 and the metal layer 16, accompanying heating. As a result, even after the carrier-attached metal foil 18 is heated at a temperature as high as, for example, 350°C or more, stable releasability can be maintained. The metal oxide layer is preferably a layer comprising an oxide of metals composed of Cu, Ti, Al, Nb, Zr, Cr, W, Ta, Co, Ag, Ni, In, Sn, Zn, Ga, Mo, or combinations thereof. The metal oxide layer is particularly preferably a layer formed by a reactive sputtering method in which sputtering is performed under an oxidizing atmosphere, using a metal target, in terms of being able to easily control film thickness by the adjustment of film formation time. The thickness of the metal oxide layer is preferably 0.1 nm or more and 100 nm or less. The upper limit value of the thickness of the metal oxide layer is more preferably 60 nm or less, further preferably 30 nm or less, and particularly preferably 10 nm or less. This thickness is a value measured by analyzing a layer cross section by a transmission electron microscope-energy dispersive X-ray spectrometer (TEM-EDX). At this time, the order in which the metal oxide layer and the carbon layer are laminated as the release layer 15 is not particularly limited. The release layer 15 may be present in a state of a mixed phase in which the boundary between the metal oxide layer and the carbon-containing layer is not clearly identified (that is, a layer comprising both a metal oxide and carbon).

Similarly, from the viewpoint of maintaining stable releasability even after heat treatment at high temperature, the release layer 15 may be a metal-containing layer in which the surface on the side adjacent to the metal layer 16 is a fluorination-treated surface and/or a nitriding-treated surface. In the metal-containing layer, a region in which the sum of the content of fluorine and the content of nitrogen is 1.0 atomic % or more (hereinafter referred to as a "(F + N) region") is preferably present over a thickness of 10 nm or more, and the (F + N) region is preferably present on the metal layer 16 side of the metal-containing layer. The thickness (in terms of SiO₂) of the (F + N) region is a value specified by performing the depth profile elemental analysis of the carrier-attached metal foil 18 using XPS. The fluorination-treated surface or the nitriding-treated surface can be preferably formed by Reactive ion etching (RIE) or a reactive sputtering method. On the other hand, the metal element included in the metal-containing layer preferably has a negative standard electrode potential. Preferred examples of the metal element included in the metal-containing layer include Cu, Ag, Sn, Zn, Ti, Al, Nb, Zr, W, Ta, Mo, and combinations thereof (for example, alloys and intermetallic compounds). The content of the metal element in the metal-containing layer is preferably 50 atomic % or more and 100 atomic % or less. The metal-containing layer may be a single layer composed of one layer or a multilayer composed of two or more layers. The thickness of the entire metal-containing layer is preferably 10 nm or more and 1000 nm or less, more preferably 30 nm or more and 500 nm or less, further preferably 50 nm or more and 400 nm or less, and particularly preferably 100 nm or more and 300 nm or less. The thickness of the metal-containing layer itself is a value measured by analyzing a layer cross section by a transmission electron microscope-energy dispersive X-ray spectrometer (TEM-EDX).

Alternatively, the release layer 15 may be a metal oxynitride-containing layer, instead of a carbon layer or the like. The surface of the metal oxynitride-containing layer opposite to the rigid carrier 12 (that is, on the metal layer 16 side) preferably comprises at least one metal oxynitride selected from the group consisting of TaON, NiON, TiON, NiWON, and MoON. In terms of ensuring the adhesion between the rigid carrier 12 and the metal layer 16, the surface of the metal oxynitride-containing layer on the rigid carrier 12 side preferably comprises at least one selected from the group consisting of Cu, Ti, Ta, Cr, Ni, Al, Mo, Zn, W, TiN, and TaN. Thus, the number of foreign matter particles on the metal layer 16 surface is suppressed to improve circuit-forming properties, and even after heating at high temperature for a long time, stable release strength can be maintained. The thickness of the metal oxynitride-containing layer is preferably 5 nm or more and 500 nm or less, more preferably 10 nm or more and 400 nm or less, further preferably 20 nm or more and 200 nm or less, and particularly preferably 30 nm or more and 100 nm or less. This thickness is a value measured by analyzing a layer cross section by a transmission electron microscope-energy dispersive X-ray spectrometer (TEM-EDX).

The metal layer 16 is a layer composed of a metal. The metal layer 16 may have a one-layer configuration or a configuration of two or more layers. When the metal layer 16 is composed of two or more layers, the metal layer 16 can have a configuration in which metal layers, a first metal layer to an m-th metal layer (m is an integer of 2 or more), are laminated in order on the surface side of the release layer 15 opposite to the rigid carrier 12. The thickness of the entire metal layer 16 is preferably 1 nm or more and 2000 nm or less, preferably 100 nm or more and 1500 nm or less, more preferably 200 nm or more and 1000 nm or less, further preferably 300 nm or more and 800 nm or less, and particularly preferably 350 nm or more and 500 nm or less. The thickness of the metal layer 16 is a value measured by analyzing a layer cross section by a transmission electron microscope-energy dispersive X-ray spectrometer (TEM-EDX). An example in which the metal layer 16 is composed of two layers, a first metal layer and a second metal layer, will be described below.

The first metal layer preferably provides the desired functions such as an etching stopper function and an antireflection function to the carrier-attached metal foil 18. Preferred examples of the metal constituting the first metal layer include Ti, Al, Nb, Zr, Cr, W, Ta, Co, Ag, Ni, Mo, and combinations thereof, more preferably Ti, Zr, Al, Cr, W, Ni, Mo, and combinations thereof, further preferably Ti, Al, Cr, Ni, Mo, and combinations thereof, and particularly preferably Ti, Mo, and combinations thereof. These elements have the property of not dissolving in flash etchants (for example, copper flash etchants) and, as a result, can exhibit excellent chemical resistance to flash etchants. Therefore, the first metal layer is a layer less likely to be etched with a flash etchant than the second metal layer described later, and therefore can function as an etching stopper layer. In addition, the metal constituting the first metal layer also has the function of preventing the reflection of light, and therefore the first metal layer can also function as an antireflection layer for improving visibility in image inspection (for example, automatic image inspection (AOI)). The first metal layer may be a pure metal or an alloy. The metal constituting the first metal layer may comprise unavoidable impurities due to the raw material component, the film formation step, and the like. The upper limit of the content of the metal is not particularly limited and may be 100 atomic %. The first metal layer is preferably a layer formed by a physical vapor deposition (PVD) method, more preferably a layer formed by sputtering. The thickness of the first metal layer is preferably 1 nm or more and 500 nm or less, more preferably 10 nm or more and 400 nm or less, further preferably 30 nm or more and 300 nm or less, and particularly preferably 50 nm or more and 200 nm or less.

Preferred examples of the metal constituting the second metal layer include the transition elements of groups 4, 5, 6, 9, 10, and 11, Al, and combinations thereof (for example, alloys and intermetallic compounds), more preferably the transition elements of groups 4 and 11, Al, Nb, Co, Ni, Mo, and combinations thereof, further preferably the transition elements of group 11, Ti, Al, Mo, and combinations thereof, particularly preferably Cu, Ti, Mo, and combinations thereof, and most preferably Cu. The second metal layer may be manufactured by any method and may be a metal foil formed, for example, by wet film formation methods such as an electroless metal plating method and an electrolytic metal plating method, physical vapor deposition (PVD) methods such as sputtering and vacuum deposition, chemical vapor film formation, or combinations thereof. A particularly preferred second metal layer is a metal layer formed by physical vapor deposition (PVD) methods such as a sputtering method and vacuum deposition, most preferably a metal layer manufactured by a sputtering method, from the viewpoint of being easily adapted to a fine pitch due to super-thinning. The second metal layer is preferably a non-roughened metal layer, but may be one in which secondary roughening occurs by preliminary roughening, soft etching treatment, rinse treatment, or oxidation-reduction treatment, as long as wiring pattern formation is not hindered. From the viewpoint of being adapted to a fine pitch, the thickness of the second metal layer is preferably 10 nm or more and 1000 nm or less, more preferably 20 nm or more and 900 nm or less, further preferably 30 nm or more and 700 nm or less, still more preferably 50 nm or more and 600 nm or less, particularly preferably 70 nm or more and 500 nm or less, and most preferably 100 nm or more and 400 nm or less. The metal layer having a thickness within such a range is preferably manufactured by a sputtering method from the viewpoint of the in-plane uniformity of film formation thickness, and productivity in a sheet form or a roll form.

When the metal layer 16 has a one-layer configuration, the second metal layer is preferably adopted as the metal layer 16 as it is. On the other hand, when the metal layer 16 has an n-layer (n is an integer of 3 or more) configuration, the first metal layer to (n-1)th metal layer of the metal layer 16 preferably have the configuration of the first metal layer, and the outermost layer, that is, the n-th metal layer, of the metal layer 16 preferably has the configuration of the second metal layer.

The end surface of the rigid carrier 12 is preferably covered by extending the metal layer 16, optionally the intermediate layer 14, and optionally the release layer 15 (that is, at least the metal layer 16, for example, the metal layer 16 and the intermediate layer 14) to the end surface. In other words, not only a surface of the rigid carrier 12 but also the end surface is preferably covered with at least the metal layer 16. By also covering the end surface, the infiltration of chemical liquids into the rigid carrier 12 in the wiring substrate manufacturing process can be prevented, and in addition, it is possible to strongly prevent chipping, that is, a chip in the film (that is, the metal layer 16) on the release layer 15, due to release at the side end when the carrier-attached metal foil 18 is handled. The covered region on the end surface of the rigid carrier 12 is preferably a region 0.1 mm or more, more preferably 0.2 mm or more, from the surface of the rigid carrier 12 toward the thickness direction (that is, the direction perpendicular to the rigid carrier surface) and is further preferably throughout the end surface of the rigid carrier 12.

### EXAMPLES

The present invention will be more specifically described by the following Examples.

### Example A1

A rigid substrate having a redistribution layer and semiconductor devices were room temperature-bonded to manufacture a multilayer substrate.

### (1) Provision of Carrier-Attached Metal Foil

A carrier-attached metal foil 18 was provided in which a titanium layer (thickness 50 nm) and a copper layer (thickness 200 nm) as an intermediate layer 14, an amorphous carbon layer (thickness 6 nm) as a release layer 15, and a titanium layer (thickness 100 nm) and a copper layer (thickness 300 nm) as a metal layer 16 were formed in this order by sputtering on a glass substrate (material: soda lime glass) having a size of a diameter of 200 mm and a thickness of 0.7 mm as a rigid carrier 12.

### (2) Formation of First Substrate and First Bumps

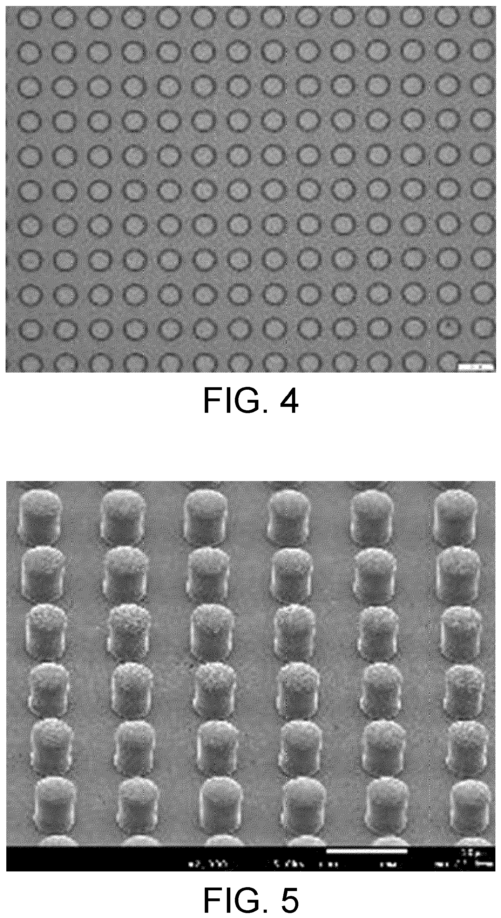

A redistribution layer 20 comprising insulating layers and wiring layers was formed on the carrier-attached metal foil 18 by a coreless build-up method to obtain a first substrate 22. Then, a plurality of first bumps 24 were formed on the redistribution layer 20 of the first substrate 22 (see Figure 1A(i)). Specifically, a photosensitive resist was applied to the surface of the first substrate 22 on the redistribution layer 20 side, and exposure and development were performed to form a photoresist layer having a predetermined pattern. Then, pattern electrolytic copper plating was performed on the exposed surface (that is, the portions not masked with the photoresist layer) of the redistribution layer 20, and then the photoresist layer was stripped to form the plurality of first bumps 24. An optical microscope observation image (magnification: 100x) and scanning electron microscope (SEM) observation image (magnification: 2000x) of the first bumps 24 provided on the first substrate 22 are shown in Figures 4 and 5 respectively. The formed first bumps 24 had a cylindrical shape having a height of 5 µm and a diameter of 5 µm and were regularly arranged at a pitch (center-to-center distance) of 10 µm.

### (3) Provision of Semiconductor Devices

Si Chips were provided as semiconductor devices 26. Second bumps 28 having a cylindrical shape having a height of 5 µm and a diameter of 5 µm were regularly formed on surfaces of the semiconductor devices 26 at a pitch of 10 µm in the same manner as the method for forming the first bumps 24 in the (2) (see Figure 1A(i)).

### (4) Cleaning Treatment

Cleaning treatment was performed on the bonding surfaces of the first bumps 24 and the bonding surfaces of the second bumps 28 in a vacuum at a pressure of 1 × 10⁻⁵ Pa or less using a room temperature wafer bonding apparatus (manufactured by Mitsubishi Heavy Industries Machine Tool Co., Ltd., BOND MEISTER, MWB-06/08AX) (see Figure 1A(ii)). Specifically, the first substrate 22 and the semiconductor devices 26 obtained in the (2) and (3) were each placed in a vacuum chamber 30, and then the gas in the vacuum chamber 30 was discharged to provide a vacuum state at the above pressure or less. Subsequently, argon atom beams were radiated for 360 seconds from fast atom beam sources as beam sources 32 toward the surface of the first substrate 22 on the side on which the first bumps 24 were provided, and the surfaces of the semiconductor devices 26 on the side on which the second bumps 28 were provided. Thus, the bonding surfaces of the first bumps 24 and the bonding surfaces of the second bumps 28 were each activated.

### (5) Pressure Welding Treatment

The room temperature bonding of the first substrate 22 and the semiconductor devices 26 was performed using the room temperature wafer bonding apparatus (see Figure 1B(iii)). Specifically, in a vacuum at a pressure of 1 × 10⁻³ Pa or less, the first substrate 22 and the semiconductor devices 26 were stacked and pressed so that the bonding surfaces of the first bumps 24 activated and the bonding surfaces of the second bumps 28 activated abut each other. At this time, the pressing load was 100 kN (the surface pressure applied to the bonding surfaces of the first bumps 24 and the second bumps 28 was 140 MPa), and pressing was performed at room temperature (25°C) without performing heating. Thus, the first bumps 24 and the second bumps 28 were pressure-welded to obtain a multilayer substrate 34 in which the first substrate 22 and the semiconductor devices 26 were bonded.

### (6) Underfill Filling and Resin Sealing

The gaps between the first substrate 22 and the semiconductor devices 26 were filled with a liquid curable resin composed of an epoxy resin (manufactured by Showa Denko Materials Co., Ltd., CEL-C-3900) in the obtained multilayer substrate 34, and then the liquid curable resin was cured to form resin layers 36 covering the first bumps 24 and the second bumps 28 (see Figure 1B (iv)). Subsequently, resin sealing was performed on the surface of the multilayer substrate 34 on the semiconductor device 26 side with a sealing material 38 composed of an epoxy resin so as to cover the semiconductor devices 26 (see Figure 1C (v)).

### Example A2

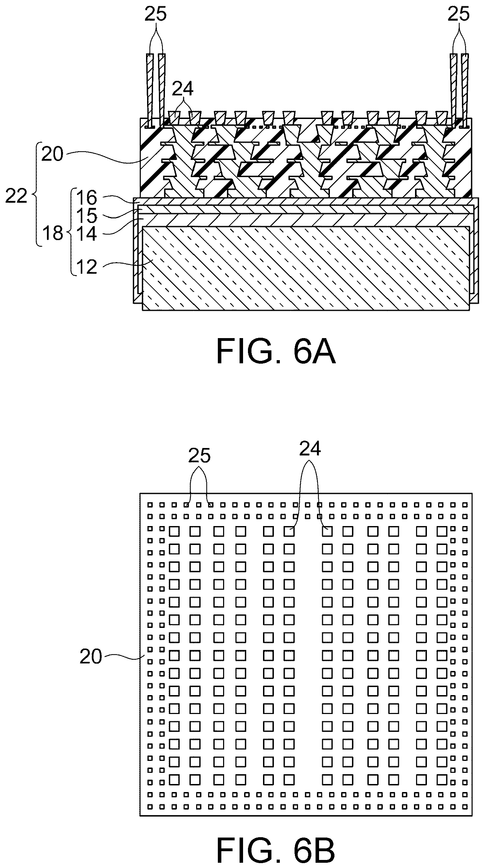

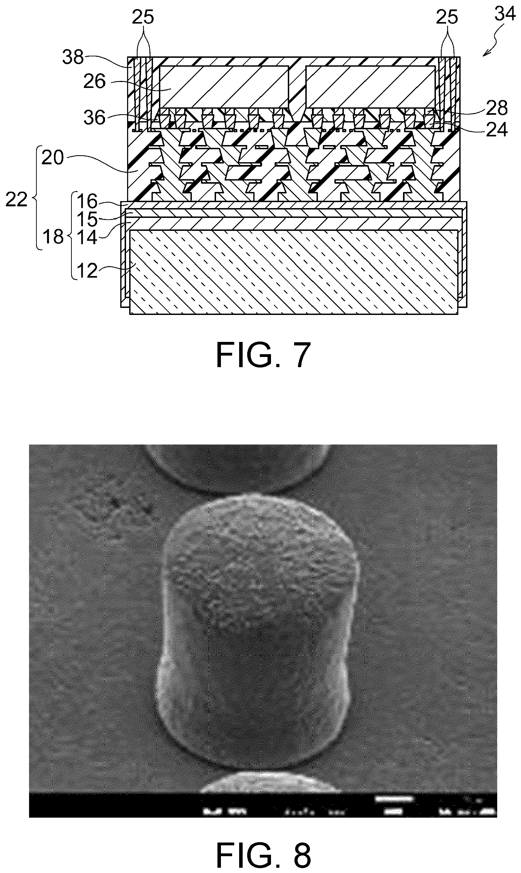

When the redistribution layer 20 comprising insulating layers and wiring layers was formed on the carrier-attached metal foil 18 by the coreless build-up method in (2) of Example A1, 96 pillars 25 having a pin shape (material: copper) were placed in the peripheral edge portion (the portion outside the first bumps 24) of the redistribution layer 20, as shown in Figures 6A and 6B. Except that, the multilayer substrate 34 in which the first substrate 22 and the semiconductor devices 26 were bonded shown in Figure 7 was obtained in the same manner as Example A1.

### Examples B1 to B8

A first substrate and a second substrate were room temperature-bonded, and the bonding strength between the bumps was evaluated.

### (1) Provision of First Substrate

A substrate was provided in which a titanium layer (thickness 50 nm) and a copper layer (thickness 200 nm) as a metal layer 16 were formed by sputtering on a glass sheet having a disk shape (material: soda lime glass) having a size of a diameter of 200 mm and a thickness of 0.7 mm as a rigid carrier 12. The substrate was used as a first substrate 22.

### (2) Formation of First Bumps

First bumps 24 were formed in a 100 mm × 100 mm rectangular region that was the central portion of the first substrate 22, by a semi-additive process. Specifically, a photosensitive resist was applied to the surface of the first substrate 22 on the copper layer side, and exposure and development were performed to form a photoresist layer having a predetermined pattern. Then, pattern electrolytic copper plating was performed on the exposed surface (that is, the portions not masked with the photoresist layer) of the copper layer, and then the photoresist layer was stripped to form the plurality of first bumps 24 in the rectangular region. The formed first bumps 24 had a cylindrical shape having a height shown in Table 1 and a diameter of 6 µm and were regularly arranged at a pitch (center-to-center distance) of 10 µm. Together with the formation of the first bumps 24, circuits for alignment marks were formed on the surface of the first substrate 22 on the copper layer side by the same method as above. These circuits were formed at positions (four places) 65 mm away from the center of the first substrate 22 to the top, bottom, left, and right.

### (3) Fabrication of Second substrate

A second substrate in which second bumps 28 were formed on a surface was fabricated in the same manner as the (1) and (2) except that the height of the second bumps 28 was as shown in Table 1.

### (4) Etching Treatment

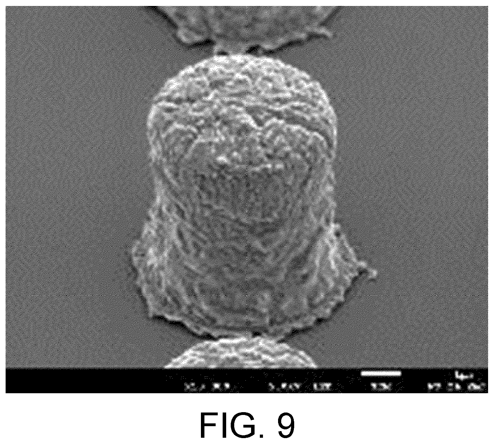

For alignment mark formation, etching treatment using a copper etchant was performed on each of the surface of the first substrate 22 on the side on which the first bumps 24 were formed, and the surface of the second substrate on the side on which the second bumps 28 were formed. At this time, for Examples B1, B3, and B5 to B8, the etching treatment was performed after the 100 mm × 100 mm rectangular regions that were the central portions of the first substrate 22 and the second substrate were each covered with a sheet so that the first bumps 24 and the second bumps 28 did not come into contact with the etchant. In contrast, for Examples B2 and B4, the etching treatment was performed without covering the regions with sheets. Here, an SEM image (magnification: 10000x) of a bump after the etching treatment in Example B1, B3, or B5 to B8 is shown in Figure 8, and an SEM image (magnification: 10000x) of a bump after the etching treatment in Example B2 is shown in Figure 9. The surface shape of the bonding surfaces of the first bumps 24 and the second bumps 28 after the etching treatment was measured in accordance with ISO 25178 under the conditions of objective lens 50x, zoom lens 20x, and a measurement range of 89 µm × 87 µm using a 3D surface roughness shape measuring machine (manufactured by Zygo, NexView). The roughness curve in the range of 3 µm × 3 µm was extracted from the obtained three-dimensional surface shape, the correction of the roughness curve was performed by the analysis program "Mx" included with the apparatus under the following correction conditions, and the arithmetic mean height Sa was calculated. The results were as shown in Table 1.

### <Correction Conditions>

- Remove: Form Remove
- Filter Type: Spline
- Filter: Low Pass
- Type: Gaussian Spline Auto

### (5) Cleaning Treatment and Room Temperature Bonding

The first bumps 24 and the second bumps 28 were pressure-welded by the same methods as (4) and (5) of Example A1 to obtain a multilayer substrate 34 in which the first substrate 22 and the second substrate were bonded.

### (6) Evaluation of Bonding Strength

In order to evaluate the bonding strength between the first bumps 24 and the second bumps 28, a peeling test was performed as follows. The second substrate side of the multilayer substrate 34 was fixed, and then peeling was performed by grasping an end of the first substrate 22 by hand. The multilayer substrate 34 after the peeling was observed. Those peeling on the bonding surfaces of the first bumps 24 and the second bumps 28 were determined as rejected, and others (for example, those peeling between the copper layer and first bumps 24 of the first substrate 22) were determined as accepted. The results were as shown in Table 1. In all of Examples B1 to B7, short circuits between the bumps and the warpage of the substrates were not noted at all.

### [Table 1]

**Table 1**

| | Bumps | | | Evaluation |
|---|---|---|---|---|
| | First bump height (µm) | Second bump height (µm) | Arithmetic mean height Sa of bump bonding surfaces (nm) | Peeling test |
| Ex. B1 | 5 | 5 | 25 | Accepted |
| Ex. B2 | 5 | 5 | 35 | Accepted |
| Ex. B3 | 5 | 0.5 | 25 | Accepted |
| Ex. B4 | 5 | 0.5 | 35 | Accepted |
| Ex. B5 | 1 | 1 | 25 | Accepted |
| Ex. B6 | 10 | 10 | 25 | Accepted |
| Ex. B7 | 30 | 30 | 25 | Accepted |
| Ex. B8* | 0.2 | 0.2 | 25 | Rejected |

| | | | | |
|---|---|---|---|---|
| * indicates a comparative example. | | | | |

### Examples C1 and C2

A first substrate and a second substrate were bonded to manufacture a wiring substrate.

### (1) Provision of First Substrate and Formation of First Bumps

A first substrate 22 on which first bumps 24 were formed was fabricated by the same methods as (1) and (2) of Examples B1 to B8 except that the height of the first bumps 24 was 5 µm.

### (2) Provision of Second Substrate

The substrate provided in (1) of Examples B1 to B8 was used as a second substrate 52. The formation of bumps was not performed on this second substrate 52.

### (3) Etching Treatment

Etching treatment using a copper etchant was performed on the surface of the first substrate 22 on the side on which the first bumps 24 were formed. At this time, for Example C1, the etching treatment was performed after the 100 mm × 100 mm rectangular region that was the central portion of the first substrate 22 was covered with a sheet so that the first bumps 24 did not come into contact with the etchant. In contrast, for Example C2, the etching treatment was performed without covering the region with a sheet. The etching treatment was not performed on the second substrate 52.

### (4) Cleaning Treatment and Pressure Welding Treatment

Cleaning treatment was performed on the bonding surfaces of the first bumps 24 and the surface of the second substrate 52 on the copper layer side by the same method as (4) of Example A1. Subsequently, the first substrate 22 and the second substrate 52 were stacked and pressed by the same method as (5) of Example A1 so that the bonding surfaces of the first bumps 24 activated and the copper layer surface of the second substrate 52 activated abut each other. Thus, a wiring substrate 56 in which the first substrate 22 and the second substrate 52 were bonded via the first bumps 24 (bumps 54) was obtained.

## Claims

1. A method for manufacturing a multilayer substrate, comprising the steps of:
providing a first substrate being a rigid substrate comprising a plurality of first bumps on a surface in a predetermined arrangement, and a second substrate or semiconductor device comprising a plurality of second bumps on a surface in an arrangement corresponding to the predetermined arrangement, each of the first bumps and the second bumps being composed of a metal or alloy having a melting point of 600°C or more, and having a height of 0.3 µm or more;
performing cleaning treatment on bonding surfaces of the first bumps and bonding surfaces of the second bumps in an atmosphere at a pressure of 1 × 10⁻³ Pa or less; and
subsequently stacking the first substrate and the second substrate or semiconductor device in an atmosphere at a pressure of 1 × 10⁻³ Pa or less so that the bonding surfaces of the first bumps and the bonding surfaces of the second bumps abut each other, and pressure-welding the first bumps and the second bumps at a temperature of 90°C or less to form a multilayer substrate.

2. The method according to claim 1, wherein the first substrate is a rigid substrate comprising a rigid carrier, a redistribution layer on the rigid carrier, and the plurality of first bumps on the redistribution layer.

3. The method according to claim 1 or 2, wherein the second substrate is a rigid substrate comprising a rigid carrier, a redistribution layer on the rigid carrier, and the plurality of second bumps on the redistribution layer.

4. The method according to any one of claims 1 to 3, wherein the cleaning treatment is at least one selected from the group consisting of ion beam irradiation, neutral atom beam irradiation, and inert gas plasma treatment.

5. The method according to any one of claims 1 to 4, wherein at least one of the first substrate and the second substrate has an elastic modulus of 30 GPa or more and 600 GPa or less.

6. The method according to any one of claims 1 to 5, wherein at least one of the first substrate and the second substrate comprises silicon or alumina.

7. The method according to any one of claims 1 to 6, wherein at least one of the first substrate and the second substrate comprises glass.

8. The method according to any one of claims 1 to 7, wherein the first bumps and the second bumps each have a height of 0.3 µm or more.

9. The method according to any one of claims 1 to 8, wherein the first bumps and the second bumps each have a circular shape having a diameter of 1 µm or more and 50 µm or less.

10. The method according to any one of claims 1 to 9, wherein the first bumps and the second bumps are regularly arranged at a pitch (center-to-center distance) of 1 µm or more and 40 µm or less.

11. The method according to any one of claims 1 to 10, wherein the bonding surfaces of the first bumps and the bonding surfaces of the second bumps each have an arithmetic mean height Sa of 0.1 nm or more and 70 nm or less.

12. The method according to any one of claims 1 to 11, wherein the first bumps and the second bumps are composed of a transition metal.

13. The method according to any one of claims 1 to 12, wherein the first bumps and the second bumps are composed of at least one selected from the group consisting of Au, Ag, and Cu.

14. The method according to any one of claims 1 to 11, wherein the first bumps and the second bumps are composed of Cu.

15. The method according to any one of claims 1 to 14, wherein the pressure welding is performed so as to apply a surface pressure of 10 MPa or more and 350 MPa or less to the bonding surfaces of the first bumps and the bonding surfaces of the second bumps.

16. The method according to any one of claims 1 to 15, further comprising the step of filling a gap between the first substrate and the second substrate or semiconductor device with a resin after the pressure welding of the first bumps and the second bumps to form a resin layer covering the first bumps and the second bumps.

17. The method according to any one of claims 1 to 16, wherein the pressure welding is performed in an environment without intentional heating and/or cooling.

18. A wiring substrate comprising:
a first substrate being a rigid substrate;
a second substrate; and
a plurality of bumps interposed between the first substrate and the second substrate and bonding the first substrate and the second substrate,
wherein the bumps are composed of a metal or alloy having a melting point of 600°C or more and have a height of 0.6 µm or more.

19. The wiring substrate according to claim 18, wherein the first substrate is a rigid substrate comprising a rigid carrier and a redistribution layer on the rigid carrier, and wherein the redistribution layer and the second substrate are bonded by the plurality of bumps.

20. The wiring substrate according to claim 19, wherein the rigid carrier is composed of glass, a substrate comprising silicon, or alumina.

21. The wiring substrate according to any one of claims 18 to 20, wherein the bumps are regularly arranged at a pitch (center-to-center distance) of 1 µm or more and 40 µm or less.
